# FASCICULE DE BREVET EUROPEEN

(11) **EP 4 197 104 B1**
(45) Date de publication et mention de la délivrance du brevet: **22.11.2023**
(21) Numéro de dépôt: 22776964.3
(22) Date de dépôt: 13.09.2022
(51) Int. Cl.: H03M 13/27

(54) **DISPOSITIF ET PROCÉDÉ D'ENTRELACEMENT DE BLOCS DE DONNÉES POUR UN SYSTÈME DE COMMUNICATIONS OPTIQUES ENTRE UN SATELLITE ET UNE STATION TERRESTRE**
VORRICHTUNG UND VERFAHREN ZUR VERSCHACHTELUNG VON DATENBLÖCKEN FÜR EIN OPTISCHES KOMMUNIKATIONSSYSTEM ZWISCHEN EINEM SATELLITEN UND EINER BODENSTATION
DEVICE AND METHOD FOR INTERLEAVING DATA BLOCKS FOR AN OPTICAL COMMUNICATION SYSTEM BETWEEN A SATELLITE AND AN EARTH STATION

(30) Priorité: 22.09.2021 FR 2109997
(43) Date de publication de la demande: 21.06.2023
(73) Titulaire: Airbus Defence and Space SAS, 31402 Toulouse Cedex 4 (FR)
(72) Inventeur: BARTHE, Lyonel, 31402 Toulouse Cedex 04 (FR); CHOUTEAU, Jean-Frédéric, 31402 Toulouse Cedex 04 (FR); GADAT, Benjamin, 31402 Toulouse Cedex 04 (FR)
(74) Mandataire: Ipside
(86) Numéro de dépôt international: PCT/EP2022/075400
(87) Numéro de publication internationale: WO 2023/046533

(56) Documents cités:
- WO-A2-2006/085251
- CHU YU ET AL: "Design of a high-speed block interleaving/deinterleaving architecture for wireless communication applications", DIGEST OF TECHNICAL PAPERS INTERNATIONAL CONFERENCE ON CONSUMER ELECTRONICS 2009, ICCE '09, IEEE, PISCATAWAY, NJ, USA, 10 janvier 2009 (2009-01-10), pages 1-2, XP031466960, ISBN: 978-1-4244-4701-5
- JAQUENOD GUILLERMO A ET AL: "A simple BLOCK interleaving algorithm using reduced memory and address generator resources", PROC. 2020 ARGENTINE CONFERENCE ON ELECTRONICS (CAE), IEEE, 27 février 2020 (2020-02-27), pages 53-56, XP033745146, DOI: 10.1109/CAE48787.2020.9046380

## Description

### Domaine de l'invention

La présente invention appartient au domaine des communications numériques par satellite, et concerne plus particulièrement un dispositif et un procédé d'entrelacement de blocs de données pour un système de communications optiques entre un satellite et une station terrestre.

### Etat de la technique

Les communications optiques spatiales reposent sur l'utilisation de faisceaux lumineux générés par des lasers pour transmettre des données. En comparaison avec les communications par ondes radio, les communications optiques permettent notamment d'accroitre le débit de données tout en réduisant la puissance électrique nécessaire pour transmettre les données.

Un signal optique transportant des données à échanger entre un satellite et une station au sol doit traverser l'atmosphère terrestre. Lors de la traversée de l'atmosphère, le faisceau lumineux véhiculant le signal émis subit un phénomène d'évanouissement (« fading » dans la littérature anglo-saxonne) qui engendre des pertes à la réception du signal. Ces pertes correspondent à des périodes d'évanouissement du signal pendant lesquelles les données véhiculées peuvent être corrompues, et donc inexploitables. Une période d'évanouissement du signal peut durer plusieurs millisecondes, voire même des dizaines ou des centaines de millisecondes. Pour des débits de données élevés (par exemple de l'ordre de 10 Gbits/s), cela signifie qu'un très grand nombre de blocs de données contigus du signal peuvent être corrompus.

Pour pallier aux erreurs de transmission engendrées par ce phénomène d'évanouissement, il est connu d'associer un dispositif d'entrelacement au traditionnel code correcteur d'erreurs. Le rôle du dispositif d'entrelacement est de disperser les bits de données qui ont potentiellement subi un même évanouissement du signal. Cela permet ainsi de limiter le nombre de bits contigus ayant subis cet évanouissement dans un paquet de données, ce qui permet un meilleur fonctionnement du code correcteur d'erreurs.

Le CCSDS (« Consultative Committee for Space Data Systems »), qui réunit notamment les principales agences spatiales mondiales, est actuellement en train de définir un standard de communication offrant un débit de l'ordre de 10 Gbits/s et permettant notamment à des satellites d'observation de transmettre rapidement au sol une quantité importante de données via une liaison optique. Ce standard préconise notamment l'utilisation de codes correcteurs d'erreurs de types « codes à contrôle de parité à faible densité » (codes LDPC, pour « Low Density Parity Check » dans la littérature anglo-saxonne), ainsi qu'un entrelacement des blocs des données encodées à transmettre.

Les solutions conventionnelles d'entrelacement de données utilisées par exemple dans les standards de téléphonie mobile 3GPP (« Third Génération Partnership Project ») ou dans le standard DVB-S2 (« Digital Video broadcast-Satellite Second Génération ») ne sont cependant pas toujours bien adaptées à ce nouveau standard développé par le CCSDS. En effet, en raison des spécificités de la communication optique visée (débit élevé à 10 Gbits/s et périodes d'évanouissement pouvant durer plusieurs centaines de millisecondes), il est nécessaire d'entrelacer un très grand nombre de trames. Il convient en outre d'utiliser des blocs d'entrelacement de petite taille pour optimiser la puissance d'entrelacement.

Le CCSDS a créé le standard HPE (acronyme anglais de « High Photon Efficiency », en français « haute efficacité photonique ») pour définir des techniques de codage, de synchronisation et d'entrelacement nécessaires à l'interopérabilité des communications optiques. Les solutions proposées dans le standard HPE reposent toutefois sur un entrelacement convolutif relativement complexe qui n'est pas adapté pour des communications à haut débit.

Il n'existe donc pas à ce jour de solution satisfaisante pour entrelacer des données à transmettre entre un satellite et une station terrestre via un lien de communication optique à haut débit.

La demande de brevet WO2006/085251A2 divulgue une méthode pour entrelacer/désentrelacer des blocs de données dans le domaine des disques optiques.

Le document *« Design of a high-speed block interleaving*/*deinterleaving architecture for wireless communication applications* », Chu Yu et al., DIGEST OF TECHNICAL PAPERS INTERNATIONAL CONFERENCE ON CONSUMER ELECTRONICS 2009, ICCE '09, IEEE, PISCATAWAY, NJ, USA, 10 janvier 2009, divulgue une méthode pour entrelacer/désentrelacer des blocs de données dans le domaine du Wi-Fi (IEEE 802.11 a/g) ou WiMax (IEEE 802.16e).

### Exposé de l'invention

La présente invention a pour objectif de remédier à tout ou partie des inconvénients de l'art antérieur, notamment ceux exposés ci-avant, en proposant un dispositif et un procédé pour entrelacer des blocs de données destinés à être transmis à très haut débit via une liaison optique entre un satellite en orbite autour de la Terre et une station terrestre. Un procédé et un dispositif de désentrelacement sont également proposés.

A cet effet, la présente invention propose, dans les revendications indépendantes 1 et 13, un dispositif et un procédé, respectivement, pour l'entrelacement de blocs de données.

Les modes de réalisation préférés sont définis dans les revendications dépendantes.

### Présentation des figures

L'invention sera mieux comprise à la lecture de la description suivante, donnée à titre d'exemple nullement limitatif, et faite en se référant aux figures 1 à 12 qui représentent :
[Fig. 1] une représentation schématique d'un système de communications optiques entre un satellite en orbite autour de la Terre et une station au sol,
[Fig. 2] un exemple de réalisation d'une chaîne de transmission comportant un dispositif d'entrelacement selon l'invention,
[Fig. 4] une première illustration d'un entrelacement de blocs de données selon un schéma d'entrelacement « ligne/colonne »,
[Fig. 5] une deuxième illustration d'un entrelacement de blocs de données selon un schéma d'entrelacement « ligne/colonne »,
[Fig. 6] une première illustration du fonctionnement d'un dispositif d'entrelacement de blocs de données selon l'invention,
[Fig. 7] une deuxième illustration du fonctionnement d'un dispositif d'entrelacement de blocs de données selon l'invention,
[Fig. 8] une troisième illustration du fonctionnement d'un dispositif d'entrelacement de blocs de données selon l'invention,
[Fig. 9] une représentation schématique des principales étapes d'un procédé d'entrelacement de blocs de données selon l'invention,
[Fig. 10] une représentation schématique d'un mode particulier de mise en oeuvre d'une phase d'écriture de trames de données dans une mémoire cache,
[Fig. 11] une représentation schématique d'un mode particulier de mise en oeuvre d'une phase d'écriture de blocs entrelacés dans une mémoire externe,
[Fig. 12] une illustration du fonctionnement d'un dispositif de désentrelacement de blocs de données selon l'invention.

Dans ces figures, des références identiques d'une figure à une autre désignent des éléments identiques ou analogues. Pour des raisons de clarté, les éléments représentés ne sont pas nécessairement à une même échelle, sauf mention contraire.

### Description détaillée d'un mode de réalisation de l'invention

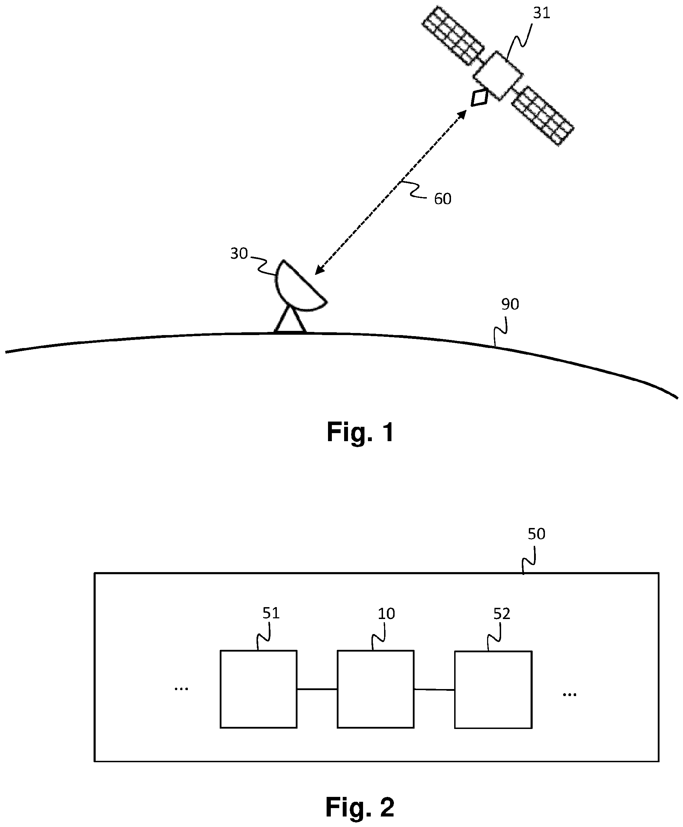

La figure 1 représente schématiquement un système de communications optiques entre un satellite 31 en orbite autour de la Terre 90 et une station terrestre 30. Dans l'exemple considéré, la station terrestre 30 est une station au sol 30 située au niveau de la surface de la Terre 90.

Un signal optique 60 transportant des données à échanger entre le satellite 31 et la station au sol 30 doit traverser l'atmosphère terrestre. Le signal est par exemple émis par le satellite 31 et reçu par la station au sol 30. Selon un autre exemple, le signal est émis par la station au sol 30 et reçu par le satellite 31.

Pour émettre le signal optique 60, le satellite 31 et/ou la station au sol 30 comporte une chaîne de transmission. La figure 2 illustre schématiquement un exemple de réalisation d'une chaîne de transmission 50. La chaîne de transmission 50 comporte différents éléments, parmi lesquels figurent notamment un dispositif 51 de codage de canal, un dispositif 10 d'entrelacement de blocs de données, et un dispositif 52 de modulation des données entrelacées. La chaîne de transmission 50 peut bien entendu comporter d'autres éléments, comme par exemple un module de génération des données à transmettre (en amont du dispositif 51 de codage de canal), et un module d'émission sur le lien optique des données modulées (en aval du dispositif 52 de modulation).

Lors de la traversée de l'atmosphère, le faisceau lumineux véhiculant le signal optique 60 subit un phénomène d'évanouissement (« fading ») qui peut engendrer des pertes de signal pouvant durer plusieurs millisecondes, voire même des dizaines ou des centaines de millisecondes. Les données véhiculées par le signal optique 60 peuvent être corrompues pendant ces périodes d'évanouissement, et devenir inexploitables pour le récepteur du signal. Lorsque le débit de données est élevé (par exemple de l'ordre de 10 Gbits/s), cela signifie qu'un très grand nombre de blocs de données contigus du signal optique 60 peuvent être corrompus.

Le dispositif 51 de codage de canal et le dispositif 10 d'entrelacement de blocs de données visent à pallier aux erreurs de décodage (au niveau du récepteur) engendrées par ce phénomène d'évanouissement.

Le dispositif 51 de codage de canal peut notamment utiliser, de façon conventionnelle, des codes correcteurs d'erreurs de types « codes à contrôle de parité à faible densité » (codes LDPC).

Le dispositif 10 d'entrelacement vise quant à lui à entrelacer des blocs de données en sortie du dispositif 51 de codage de canal pour les transmettre de façon non-contiguë, afin d'améliorer à la réception les performances en termes de détection et de correction d'erreurs. Le but de l'entrelacement des blocs de données est de disperser les bits de données qui ont potentiellement subi un même évanouissement du signal pendant la traversée de l'atmosphère. Cela permet ainsi de limiter le nombre de bits ayant subis un même évanouissement dans un paquet de données utilisé au moment du décodage par le récepteur.

Les blocs entrelacés en sortie du dispositif 10 d'entrelacement sont fournis au dispositif 52 de modulation.

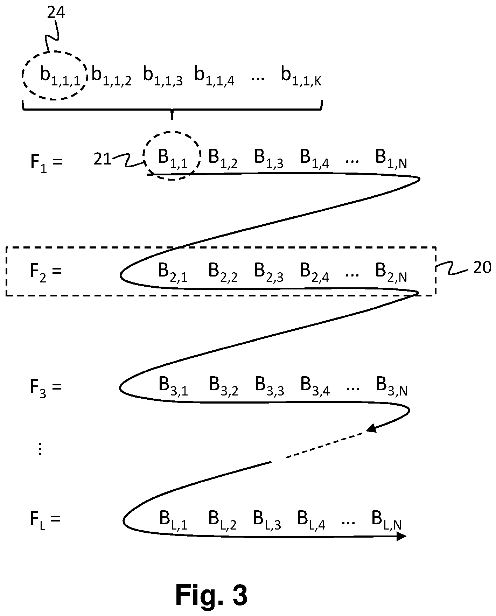

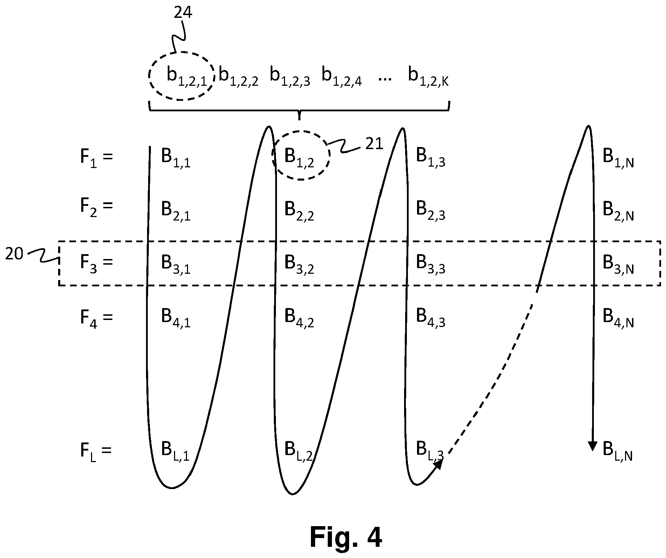

Les figures 3 et 4 illustrent schématiquement le fonctionnement du dispositif 10 d'entrelacement selon un schéma d'entrelacement dit « ligne/colonne ».

Tel qu'illustré sur la figure 3, le dispositif 10 d'entrelacement reçoit en entrée des trames 20 de données selon l'ordre indiqué par la flèche : d'abord la trame de données F₁, puis la trame F₂, la trame F₃, ... et la trame F_{L}. Les trames 20 de données proviennent du dispositif 51 de codage de canal. Chaque trame 20 de données comporte plusieurs blocs 21 de données. Dans l'exemple considéré, chaque trame 20 de données comporte N blocs 21 de données. Sur l'exemple illustré à la figure 3, la trame F₁ comporte les blocs 21 de données B_{1,1}, B_{1,2}, B_{1,3}, ..., B_{1,N} ; la trame F₂ comporte les blocs 21 de données B_{2,1}, B_{2,2}, B_{2,3}, ..., B_{2,N} ; ... ; la trame F_{L} comporte les blocs 21 de données B_{L,1}, B_{L,2}, B_{L,3}, ..., B_{L,N}. Chaque bloc 21 de données comporte plusieurs bits 24 de données. Dans l'exemple considéré, chaque bloc 21 de données comporte K bits 24 de données. Sur l'exemple illustré à la figure 3, le bloc 21 de données B_{1,1} comporte les bits 24 de données b_{1,1,1}, b_{1,1,2}, b_{1,1,3}, ..., b_{1,1,K}.

Le dispositif 10 d'entrelacement reçoit en entrée les blocs 21 de données selon l'ordre indiqué par la flèche : d'abord le bloc B_{1,1}, puis le bloc B_{1,2}, le bloc B_{1,3}, ..., le bloc B_{1,N}, le bloc B_{2,1}, le bloc B_{2,2}, ..., le bloc B_{2,N}, ..., le bloc B_{3,1}, ..., le bloc B_{3,N}, ..., le bloc B_{L,1}, ..., le bloc B_{L,N}. Sur la figure 3, une ligne correspond à une trame 20 de données, et les blocs 21 de données reçus successivement en entrée du dispositif 10 d'entrelacement correspondent aux blocs 21 de données lus ligne par ligne.

Tel qu'illustré sur la figure 4, le dispositif 10 d'entrelacement fournit en sortie des blocs 21 de données entrelacés selon l'ordre indiqué par la flèche : d'abord le bloc B_{1,1}, puis le bloc B_{2,1}, le bloc B_{3,1}, ..., le bloc B_{L,1}, le bloc B_{1,2}, le bloc B_{2,2}, ..., le bloc B_{L,2}, le bloc B_{1,3}, le bloc B_{2,3}, ..., le bloc B_{L,3}, ..., le bloc B_{1,N}, le bloc B_{2,N}, ..., le bloc B_{L,N}. Autrement dit, les blocs 21 de données entrelacés fournis en sortis du dispositif 10 d'entrelacement correspondent aux blocs 21 de données lus colonne par colonne.

Le système de communications optiques vise à supporter un débit de données élevé, notamment un débit au moins égal à 1 Gbits/s (gigabits par seconde). Dans l'exemple considéré, le débit de données visé est égal à 10 Gbits/s. Des débits encore plus élevés pourraient toutefois être envisagés.

Les périodes d'évanouissement engendrées par la traversée de l'atmosphère peuvent durer plusieurs dizaines de millisecondes, voire plusieurs centaines de millisecondes. Il est donc nécessaire d'entrelacer un très grand nombre de trames. Dans l'exemple considéré, le nombre L de trames entrelacées par le dispositif 10 d'entrelacement est égal à 32640 (L = 32640).

Il convient d'autre part d'utiliser des blocs d'entrelacement de petite taille pour optimiser la puissance d'entrelacement. Plus la taille d'un bloc 21 de données est petite, et plus la puissance d'entrelacement est forte. Autrement dit, plus la taille d'un bloc 21 de données est petite, et meilleure est l'efficacité de l'entrelacement pour disperser les blocs de données et limiter l'impact du phénomène d'évanouissement. La taille d'un bloc 21 de données est définie par le nombre K de bits contenus dans le bloc 21 de données. De préférence, la taille K d'un bloc de données est inférieure ou égale à 2048 bits. De façon encore plus préférentielle, la taille K d'un bloc de données est inférieure ou égale à 1024 bits, voire inférieure à 256 bits. Dans l'exemple considéré, la taille K d'un bloc de données est égale à 128 bits (K = 128).

De manière avantageuse, le nombre N de blocs 21 de données contenus dans une trame 20 de données est au moins égal à 60. Dans l'exemple considéré, une trame de données comporte 30720 bits de données ; une trame de données comporte donc 240 blocs de données (K = 128 ; N = 240 ; K x N = 30720).

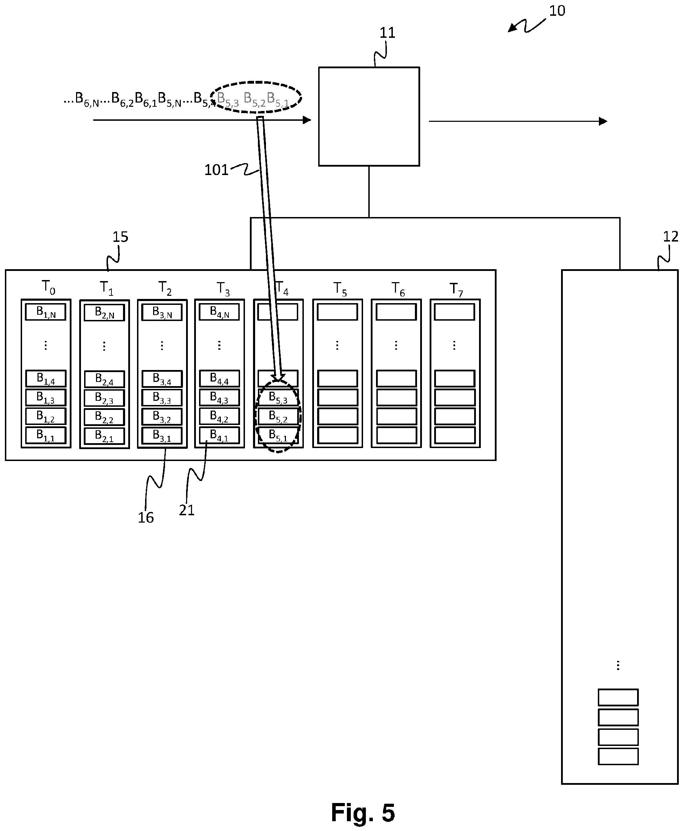

Les figures 5 à 8 décrivent plus en détail le dispositif 10 d'entrelacement. Le dispositif 10 d'entrelacement comporte notamment un module de contrôle 11 intégré sur un circuit électronique. Le circuit électronique est par exemple un circuit programmable : un circuit FPGA (acronyme anglais de « Field Programmable Gate Arrays »), ou un circuit PLD (acronyme anglais de « Programmable Logic Device »), etc. Selon un autre exemple, le circuit électronique est un circuit intégré spécifique, par exemple un circuit ASIC (acronyme anglais de « Application-Specific Integrated Circuit »). Le module de contrôle 11 est configuré pour exécuter des instructions de code de programme qui mettent en oeuvre certaines étapes d'un procédé d'entrelacement des blocs 21 de données en entrée du dispositif 10 d'entrelacement.

Comme le nombre de blocs à entrelacer est très grand, il convient d'utiliser une mémoire externe 12 offrant un volume de stockage important, comme par exemple une mémoire vive dynamique de type DRAM (acronyme anglais pour « Dynamic Random Access memory »). Cette mémoire externe 12 peut être distincte du circuit électronique comprenant le module de contrôle 11 (autrement dit, la mémoire externe 12 ne fait pas partie du circuit électronique comprenant le module de contrôle 11). La mémoire externe 12 permet de gérer l'entrelacement d'un grand nombre de trames (la mémoire externe 12 peut en effet offrir un volume de stockage important pour mémoriser un grand nombre de blocs de données).

Les accès en écriture à la mémoire externe 12 par le module de contrôle 11 peuvent notamment être réalisés, de façon conventionnelle, via un contrôleur de type DMA (acronyme anglais pour « Direct Memory Access », en français « accès direct à la mémoire »).

Il convient toutefois de noter que l'utilisation d'une mémoire externe 12 de type DRAM n'est pas essentielle à l'invention, et que d'autres types de mémoire pourraient éventuellement être envisagées. L'utilisation d'une mémoire externe 12 de type DRAM offre toutefois un bon compromis en termes de temps d'accès, de bande passante théorique, de volume de stockage, de coût et d'endurance. Il est également à noter que le terme DRAM englobe plusieurs types de mémoire, par exemple les mémoires de type DDR SDRAM (acronyme anglais pour « Double Data Rate Synchronous Dynamic Random Access Memory »), les mémoires de type HBM (acronyme anglais pour « High-Bandwidth Memory »), etc.

Les performances d'une mémoire de type DRAM sont cependant meilleures lorsque chaque accès en écriture à la mémoire est effectué pour écrire un grand nombre de données dans une zone séquentielle (contigüe) de la mémoire. Les performances d'une mémoire de type DRAM se dégradent en revanche rapidement lorsque les données sont écrites dans la mémoire sous la forme d'écritures successives d'un petit nombre de données dans des zones non contiguës.

Pour pallier ce problème, le dispositif 10 d'entrelacement selon l'invention prévoit d'utiliser une mémoire cache 15 intermédiaire permettant de mémoriser temporairement plusieurs trames 20 de données afin de former un groupe 22 de blocs 21 de données entrelacés à écrire dans une zone séquentielle 13 de la mémoire externe 12 (on entend par « zone séquentielle » une section contigüe de blocs de la mémoire externe 12). Chaque accès en écriture à la mémoire externe 12 peut ainsi correspondre à une écriture d'un groupe 22 de plusieurs blocs 21 de données entrelacés. De telles dispositions permettent d'éviter d'avoir à écrire chaque bloc 21 de données l'un après l'autre dans la mémoire externe 12. De préférence la taille K d'un bloc 21 de données et le nombre N_{B} de blocs formant un groupe 22 de blocs à écrire dans une zone séquentielle 13 de la mémoire externe 12 sont choisis de sorte que le produit entre N_{B} et K est au moins égal à 1024 (N_{B} × K ≥ 1024).

La mémoire cache 15 peut notamment être intégrée au circuit électronique comprenant le module de contrôle 11. Rien n'empêche toutefois que la mémoire cache 15 corresponde à un circuit électronique distinct du circuit électronique comprenant le module de contrôle 11. La mémoire cache 15 est par exemple une mémoire de type SRAM (acronyme anglais pour « Static Random Access Memory »). Une mémoire de type SRAM est plus onéreuse, moins dense et plus énergivore qu'une mémoire de type DRAM, mais elle offre de meilleures performances en termes de temps d'accès et de bande passante.

Dans l'exemple considéré, et tel qu'illustré sur les figures 5 à 8, la mémoire cache 15 comporte huit zones tampons 16 (ces zones tampons sont nommées T₀, T₁ , T₂, ..., T₇). Chaque zone tampon 16 présente une taille au moins égale à la taille d'une trame 20 de données. Chaque zone tampon 16 peut ainsi permettre de mémoriser temporairement une trame 20 de données.

De préférence, le nombre de zones tampons 16 est pair. Par exemple, le nombre de zones tampons est égal à quatre, huit ou seize.

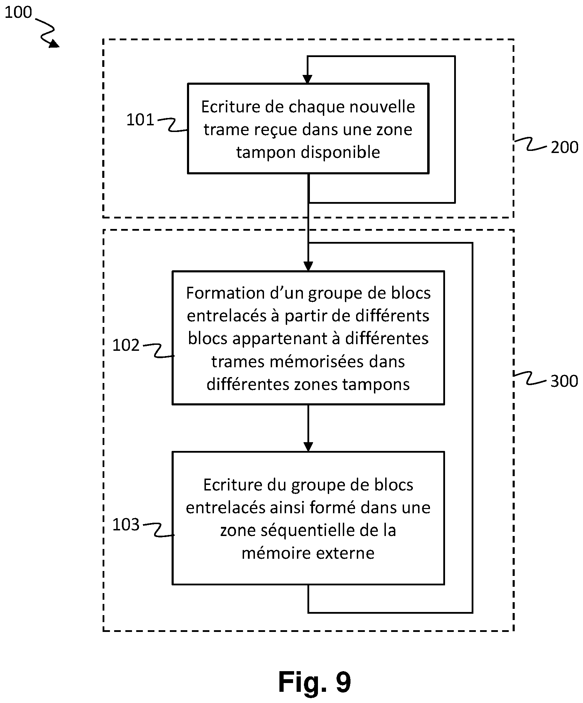

Les figures 5 à 8 illustrent différentes étapes 101 à 104 mises en oeuvre par le module de contrôle 11 pour entrelacer des blocs 21 de données. La figure 9 décrit également ces différentes étapes sous la forme d'un procédé 100 d'entrelacement mis en oeuvre par le module de contrôle 11.

La figure 5 et la figure 9 décrivent notamment, pour chaque nouvelle trame 20 de données reçue en entrée du dispositif 10 d'entrelacement, une étape d'écriture 101 de ladite trame 20 de données dans une zone tampon 16 disponible. La répétition de ces différentes étapes d'écriture 101 correspondent à une phase d'écriture 200 des trames 20 dans la mémoire cache 15.

Sur la figure 5, la trame F₁ comprenant les blocs de données B_{1,1} à B_{1,N} est mémorisée dans la zone tampon T₀ ; la trame F₂ comprenant les blocs de données B_{2,1} à B_{2,N} est mémorisée dans la zone tampon T₁ ; la trame F₃ comprenant les blocs de données B_{3,1} à B_{3,N} est mémorisée dans la zone tampon T₂ ; la trame F₄ comprenant les blocs de données B_{4,1} à B_{4,N} est mémorisée dans la zone tampon T₃. Sur la figure 5, le dispositif d'entrelacement 10 est en cours de réception de la trame F₅ : les blocs 21 de données B_{5,1}, B_{5,2} et B_{5,3} sont déjà mémorisés dans la zone tampon T₄. Les blocs suivants B_{5,4} à B_{5,N} de la trame F₅ seront mémorisés dans la zone tampon T₄ au fur et à mesure de leur réception.

Chaque nouvelle trame 20 de données reçue en entrée du dispositif 10 d'entrelacement est ainsi successivement mémorisée dans une zone tampon 16 disponible. Une zone tampon 16 est considérée comme disponible si et seulement si elle ne contient pas de bloc 21 de données n'ayant pas encore été utilisé pour former un groupe 22 de blocs entrelacés à écrire dans la mémoire externe 12. Sur la figure 5, les zones tampons T₅, T₆ et T₇ sont disponibles pour mémoriser respectivement les trames F₆, F₇ et F₈ qui seront prochainement reçues par le dispositif 10 d'entrelacement.

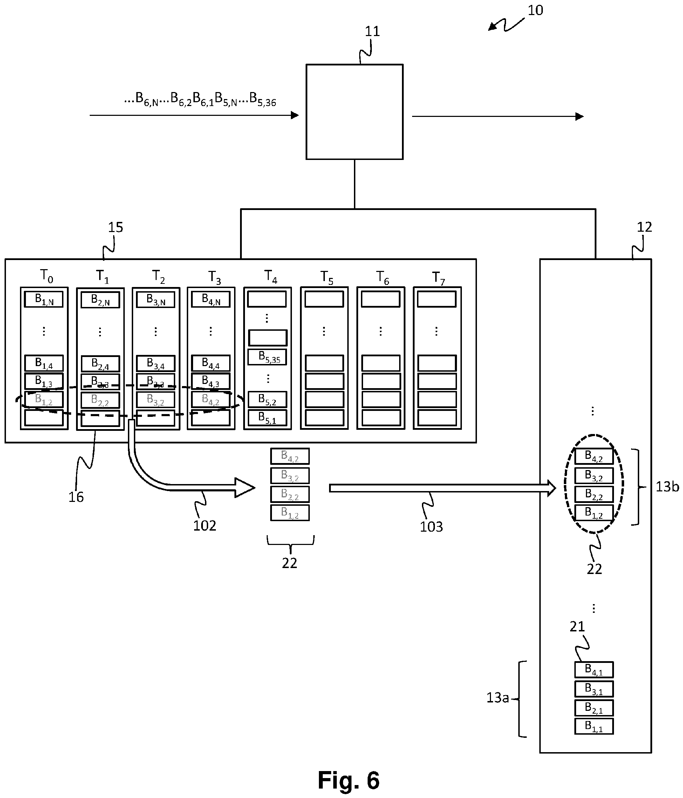

Les figures 6, 7 et 9 décrivent l'étape de formation 102 d'un groupe 22 de blocs entrelacés à partir de différents blocs 21 appartenant à différentes trames 20 mémorisées dans différentes zones tampons 16. Ces figures décrivent également une étape d'écriture 103 du groupe 22 de blocs entrelacés ainsi formé dans une zone séquentielle 13 de la mémoire externe 12. La répétition de ces différentes étapes 102 et 103 correspondent à une phase d'écriture 300 de groupes 22 de blocs dans la mémoire externe 12.

Sur la figure 6, le dispositif d'entrelacement 10 est toujours en cours de réception de la trame F₅ : les blocs 21 de données B_{5,1} à B_{5,35} sont mémorisés dans la zone tampon T₄. Les blocs suivants B_{5,36} à B_{5,N} de la trame F₅ seront mémorisés dans la zone tampon T₄ au fur et à mesure de leur réception. En outre, un premier groupe 22 de blocs 21 entrelacés comprenant les blocs B_{1,1}, B_{2,1}, B_{3,1} et B_{4,1} a déjà été formé puis écrit dans une zone séquentielle 13a de la mémoire externe 12. La figure 6 illustre la formation 102 d'un deuxième groupe 22 de blocs entrelacés, et l'écriture 103 de ce groupe 22 de blocs entrelacés dans une autre zone séquentielle 13b de la mémoire externe 12. Ce deuxième groupe 22 de blocs entrelacés comprend les blocs B_{1,2}, B_{2,2}, B_{3,2} et B_{4,2} extraits respectivement des zones tampons T₀, T₁, T₂ et T₃. Chaque groupe 22 de blocs entrelacés à écrire dans une zone séquentielle de la mémoire externe sont extraits de différentes trames 20 de données mémorisées dans différentes zones tampons 16. On peut noter que la zone séquentielle 13a et la zone séquentielle 13b ne sont pas contigües. En effet, les blocs mémoires disponibles entre ces deux zones seront utilisées pour y mémoriser ultérieurement les blocs entrelacés B_{5,1} à B_{L,1}.

Dans l'exemple considéré, chaque groupe 22 de blocs entrelacés comprend quatre blocs 21 de données. Chaque groupe 22 de blocs entrelacés à écrire dans une zone séquentielle de la mémoire externe 12 comporte donc 512 bits (quatre fois plus que la taille d'un bloc 21 de données). Cela permet ainsi d'optimiser les accès en écriture vers la mémoire externe 12. Il est en effet beaucoup plus performant de faire un unique accès en écriture de 512 bits plutôt que quatre accès en écriture de 128 bits.

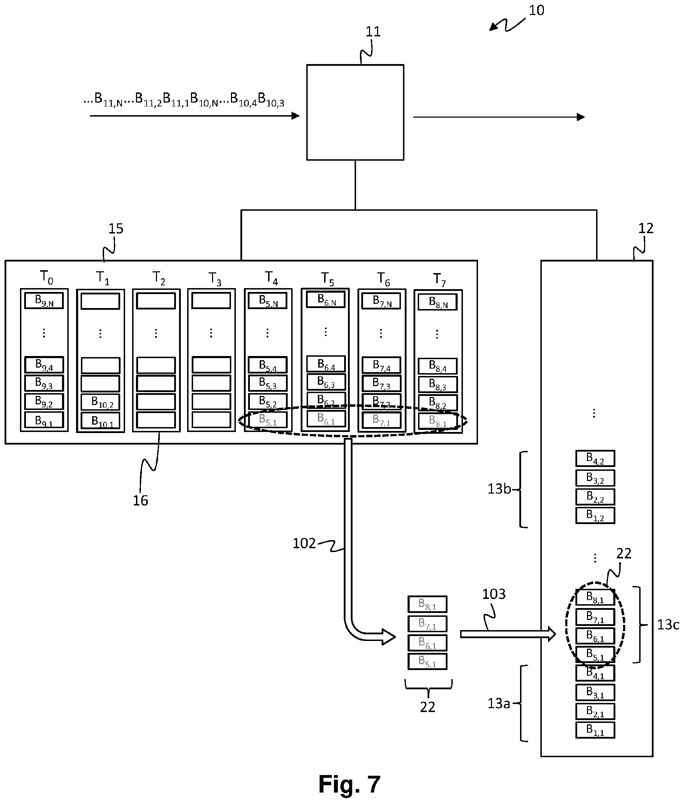

Sur la figure 7, le dispositif d'entrelacement 10 est en cours de réception de la trame F₁₀ : les blocs 21 de données B_{10,1} et B_{10,2} sont mémorisés dans la zone tampon T₁. Les blocs suivants B_{10,3} à B_{10,N} de la trame F₁₀ seront mémorisés dans la zone tampon T₁ au fur et à mesure de leur réception. La trame F₁₁ sera ensuite mémorisée dans la zone tampon T₂ qui est disponible. La trame F₁₂ sera ensuite mémorisée dans la zone tampon T₃.

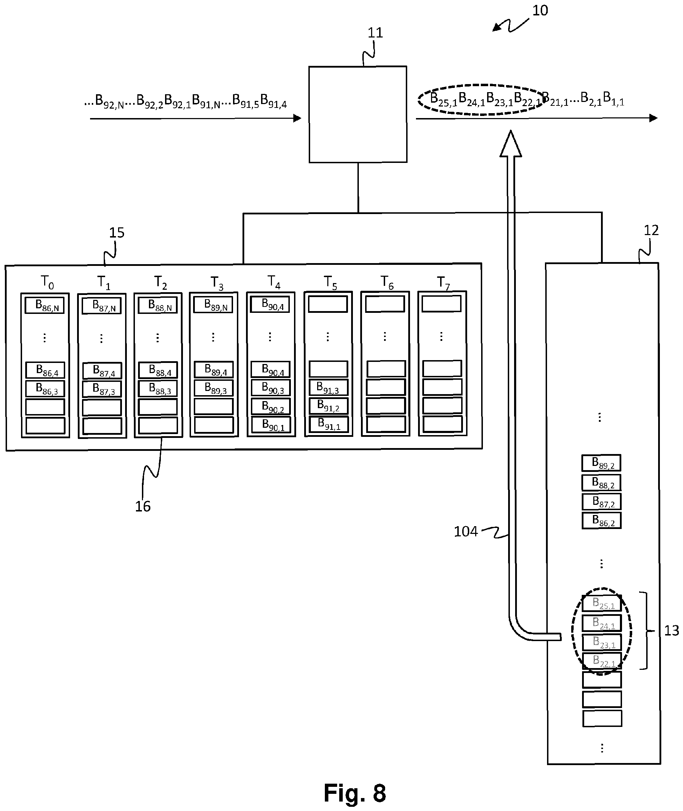

La figure 7 illustre en outre la formation 102 d'un groupe 22 de blocs entrelacés comprenant les blocs B_{5,1}, B_{6,1}, B_{7,1} et B_{8,1} à partir de blocs de données des trames F₅, F₆, F₇ et F₈ qui ont été mémorisées respectivement dans les zones tampons T₄, T₅, T₆ et T₇. La figure 8 illustre également l'écriture 103 de ce groupe 22 de blocs entrelacés dans une zone séquentielle 13c de la mémoire externe 12. La zone séquentielle 13c est contigüe avec la zone séquentielle 13a.

Le dispositif 10 d'entrelacement de données est dimensionné de telle sorte qu'au moment où la trame F₁₃ arrivera, tous les blocs mémorisés dans les zones tampons T₄ à T₇ auront été extraits pour former des groupes de blocs entrelacés à écrire dans la mémoire externe 12. Ainsi la zone tampon T₄ sera disponible pour mémoriser la trame F₁₃.

La figure 8 décrit quant à elle une étape de lecture 104 d'un groupe de blocs entrelacés mémorisés dans une zone séquentielle 13 de la mémoire externe 12. Sur l'exemple illustré à la figure 8, les blocs entrelacés lus sont les blocs B_{22,1}, B_{23,1}, B_{24,1} et B_{25,1}. Ces blocs sont fournis en sortie du dispositif 10 d'entrelacement et mis à disposition du dispositif 52 de modulation. Sur l'exemple illustré à la figure 8, les blocs entrelacés B_{1,1} à B_{22,1} avaient déjà précédemment été lus de la mémoire externe 12 et fournis en sortie du dispositif 10 d'entrelacement.

Il convient de noter que le nombre de blocs à lire dans une zone séquentielle de la mémoire externe 12 pendant l'étape de lecture 104 n'est pas nécessairement aligné sur le nombre N_{B} de blocs formant un groupe de blocs lors de l'écriture dans la mémoire externe 12. Par exemple, il est envisageable d'écrire, au cours de l'étape d'écriture 103, des groupes de quatre blocs de 128 bits (N_{B} = 4, K = 128) et de lire, au cours de l'étape 104, des groupes de huit blocs de 128 bits. Il convient toutefois que les blocs qui sont lus au cours de l'étape 104 soient contigus dans la mémoire externe 12. Dans l'exemple considéré et illustré à la figure 8, le même nombre de blocs forment un groupe à écrire et un groupe à lire dans la mémoire externe 12.

On peut noter en outre sur la figure 8 que le dispositif 10 d'entrelacement est en cours de réception de la trame F₉₁ qui est temporairement mémorisée dans la zone tampon T₅. Les groupes de blocs entrelacés sont actuellement formés à partir des trames F₈₆, F₈₇, F₈₈, et F₈₉ mémorisées respectivement dans les zones tampons T₀, T₁, T₂, et T₃,

La phase d'écriture 200 des trames 20 dans la mémoire cache 15, la phase d'écriture 300 des groupes 22 de blocs dans la mémoire externe 12, et la phase de lecture des blocs entrelacés dans la mémoire externe 12, sont exécutées en parallèle l'une de l'autre.

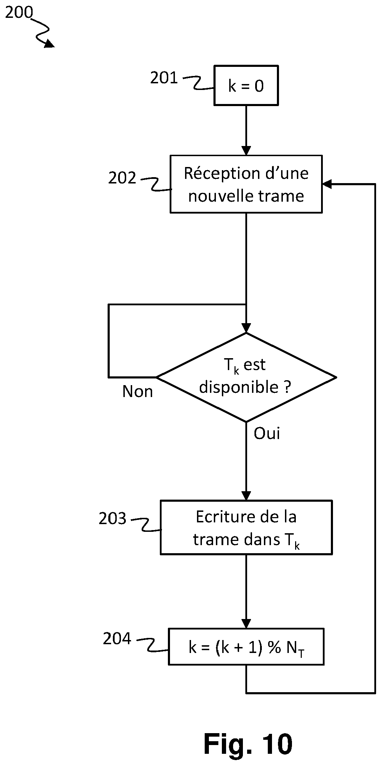

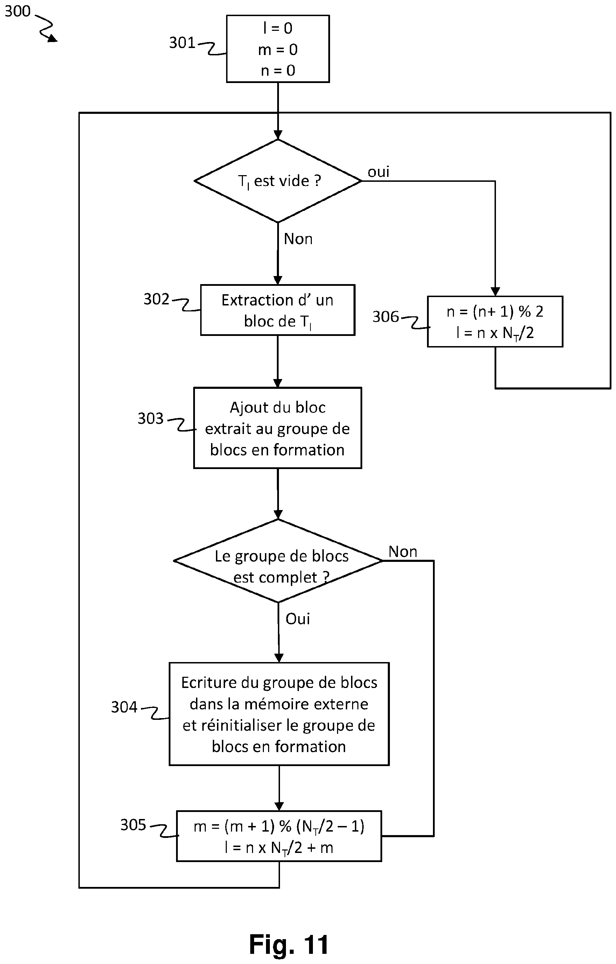

Les figures 10 et 11 représentent respectivement la phase d'écriture 200 des trames 20 dans la mémoire cache 15, et la phase d'écriture 300 des groupes 22 de blocs dans la mémoire externe 12, pour un mode particulier de mise en oeuvre du procédé 100 d'entrelacement par le dispositif 10 d'entrelacement. Dans ce mode particulier de mise en oeuvre, il est considéré que le nombre N_{T} de zones tampons 16 est égal au double du nombre N_{B} de blocs d'un groupe 22 de blocs entrelacés à écrire dans la mémoire externe 12 (N_{T} = 8 et N_{B} = N_{T}/2 = 4 dans l'exemple considéré).

Tel qu'illustré sur la figure 10, la phase d'écriture 200 des trames 20 dans la mémoire cache 15 comporte les étapes suivantes :
- une initialisation 201 d'un indice k à zéro (k = 0), l'indice k pouvant varier entre 0 et (N_{T} -1) afin d'identifier les zones tampons T₀ à T₇ ;
- une réception 202 d'une nouvelle trame 20 de données par le dispositif 10 d'entrelacement ;
- pour chaque nouvelle trame 20 reçue :
   ∘ une écriture 203 de la trame 20 reçue dans la zone tampon 16 d'indice k,
   ∘ une incrémentation 204 modulo N_{T} de l'indice k d'une unité (k = (k+1) % N_{T}).
Si la zone tampon 16 d'indice k n'est pas disponible, il convient d'attendre qu'elle le devienne. Une boucle d'attente active peut être mise en place dans ce but. Il est toutefois possible de dimensionner le dispositif 10 d'entrelacement pour que le rapport entre la vitesse d'écriture des blocs entrelacés dans la mémoire externe 12 et la vitesse d'écriture des trames 20 dans les zones tampons de la mémoire cache 15 soit tel que la zone tampon d'indice k est toujours disponible au moment où une nouvelle trame doit y être mémorisée.

Tel qu'illustré sur la figure 11, la phase d'écriture 300 des groupes 22 de blocs dans la mémoire externe 12 comporte les étapes suivantes :
- une initialisation 301 d'indices I, m et n à zéro (l = 0 ; m 0 ; n 0) ; I est un indice variant entre 0 et (N_{T} -1) pour identifier une zone tampon ; m est un indice variant entre 0 et (N_{T}/2 - 1) ; n est un indice variant entre 0 et 1.
- tant qu'il reste des blocs 21 à extraire dans la zone tampon 16 d'indice I :
   ∘ une extraction 302 d'un bloc 21 de la zone tampon 16 d'indice I,
   ∘ un ajout 303 du bloc extrait au groupe 22 de blocs entrelacés à former,
   ∘ si le groupe 22 de blocs comprend N_{T}/2 blocs (c'est-à-dire si le groupe 22 de blocs est complet), une écriture 304 du groupe 22 de blocs dans une zone séquentielle 13 de la mémoire externe 12,
   ∘ une incrémentation 305 modulo (N_{T}/2 -1) de l'indice m d'une unité,
   ∘ une attribution 305 à l'indice I de la valeur (n x N_{T}/2 + m),
- quand tous les blocs 21 de la trame 20 mémorisée dans la zone tampon 16 d'indice I ont été extraits :
   ∘ une incrémentation 306 modulo 2 de l'indice n d'une unité,
   ∘ une attribution 306 à l'indice I de la valeur (n x N_{T}/2).

Les principes décrits ci-avant peuvent être réutilisés pour mettre en oeuvre un dispositif et une méthode de désentrelacement des blocs 21 de données au niveau du récepteur. Le dispositif de désentrelacement est par exemple implémenté dans une chaîne de réception comportant en outre un dispositif de réception de données sur le lien de communication optique, un dispositif de démodulation, et un dispositif de décodage de canal. Des données entrelacées reçues par le dispositif de réception sont fournies au dispositif de démodulation. Le dispositif de démodulation fournit des blocs de données entrelacées en entrée du dispositif de désentrelacement. Le dispositif de désentrelacement est configuré pour fournir en sortie des trames de blocs de données ordonnés. Les blocs de données ordonnés en sortie du dispositif de désentrelacement sont mis à disposition du dispositif de décodage de canal.

Le dispositif de désentrelacement peut notamment être inclus dans une chaîne de réception du satellite 31 et/ou dans une chaîne de réception de la station au sol 30 décrits en référence à la figure 1.

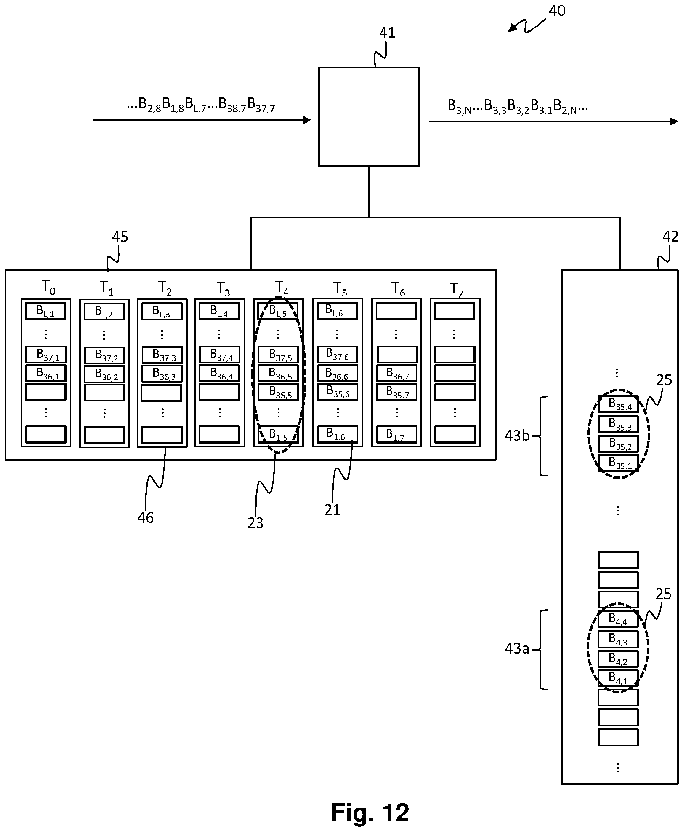

La figure 12 décrit un exemple de dispositif 40 de désentrelacement. Le dispositif 10 de désentrelacement comporte notamment un module de contrôle 41 intégré sur un circuit électronique. Le circuit électronique est par exemple un circuit programmable de type FPGA, PLD ou ASIC. Le module de contrôle 41 est configuré pour exécuter des instructions de code de programme qui mettent en oeuvre certaines étapes d'un procédé de désentrelacement des blocs 21 de données en entrée du dispositif 40 de désentrelacement.

Le dispositif 40 de désentrelacement comporte en outre une mémoire externe 42, par exemple de type DRAM, destinée à mémoriser les blocs de données ordonnés. Cette mémoire 42 peut être distincte du circuit électronique comprenant le module de contrôle 41.

Le dispositif 40 de désentrelacement comporte en outre une mémoire cache 45 permettant de mémoriser temporairement plusieurs ensembles 23 de données entrelacées afin de former un groupe 25 de blocs 21 de données ordonnés à écrire dans une zone séquentielle 43 de la mémoire externe 42.

Chaque accès en écriture à la mémoire externe 42 peut ainsi correspondre à une écriture d'un groupe 25 de plusieurs blocs 21 de données ordonnés. De telles dispositions permettent d'éviter d'avoir à écrire chaque bloc 21 de données l'un après l'autre dans la mémoire externe 42.

La mémoire cache 45 peut notamment être intégrée au circuit électronique comprenant le module de contrôle 41. Rien n'empêche toutefois que la mémoire cache 15 corresponde à un circuit électronique distinct du circuit électronique comprenant le module de contrôle 11. La mémoire cache 45 est par exemple une mémoire de type SRAM.

On peut noter que dans le cas de l'entrelacement (à l'émission) la taille de la mémoire cache (15) est dimensionnée par le nombre N de blocs 21 formant une trame 20 de données, alors que dans le cas du désentrelacement (à la réception) la taille de la mémoire cache (15) est dimensionnée par le nombre L de trames entrelacées. Si la quantité de SRAM nécessaire est très importante, il est envisageable d'utiliser plusieurs puces SRAMs dédiées.

Dans l'exemple considéré, et tel qu'illustré sur la figure 12, la mémoire cache 45 comporte huit zones tampons 46 (ces zones tampons sont nommées T₀, T₁, T₂, ..., T₇). Chaque zone tampon 46 présente une taille au moins égale à la taille d'un ensemble 23 de blocs de données entrelacées. Chaque zone tampon 46 peut ainsi permettre de mémoriser temporairement un ensemble 23 de blocs 21 de données entrelacés.

Le module de contrôle 41 est notamment configuré pour :
- écrire dans une zone tampon 46 disponible chaque nouvel ensemble 23 de L blocs 21 entrelacés successivement reçu en entrée du dispositif 40 de désentrelacement,
- former des groupes 25 de blocs ordonnés à partir de différents blocs 21 appartenant à différents ensembles 23 de blocs mémorisés dans différentes zones tampons 46,
- écrire chaque groupe 25 de blocs ordonnés ainsi formé dans une zone séquentielle 43 de la mémoire externe 42.
Une zone tampon 46 est considérée comme disponible si et seulement si elle ne contient pas de bloc 21 n'ayant pas encore été utilisé pour former un groupe 25 de blocs 21 ordonnés à écrire dans la mémoire externe 42.

Sur la figure 12, l'ensemble 23 de blocs 21 de données entrelacés correspondant aux blocs B_{1,1} à B_{L,1} a été mémorisé dans la zone tampon T₀. L'ensemble 23 correspondant aux blocs entrelacés B₁,₂ à B_{L,2} a été mémorisé dans la zone tampon T₁. L'ensemble 23 correspondant aux blocs entrelacés B_{1,3} à B_{L,3} a été mémorisé dans la zone tampon T₂. L'ensemble 23 correspondant aux blocs entrelacés B_{1,4} à B_{L,4} a été mémorisé dans la zone tampon T₃. L'ensemble 23 correspondant aux blocs entrelacés B_{1,5} à B_{L,5} a été mémorisé dans la zone tampon T₄. L'ensemble 23 correspondant aux blocs entrelacés B_{1,6} à B_{L,6} a été mémorisé dans la zone tampon T₅. L'ensemble 23 correspondant aux blocs entrelacés B_{1,7} à B_{L,7} est en cours de réception par le dispositif de désentrelacement 41 : les blocs B_{1,7} à B_{36,7} sont déjà mémorisés dans la zone tampon T₆, les blocs suivants B_{37,7} à B_{L,7} seront mémorisés dans la zone tampon T₆ au fur et à mesure de leur réception. Les ensembles 23 mémorisés dans les zones tampons T₀ à T₃ sont actuellement utilisés pour former des groupes 25 de blocs ordonnés à écrire dans la mémoire externe 42. On peut observer notamment que le groupes 25 de blocs ordonnés B_{4,1} à B_{4,4} a été mémorisée dans une zone séquentielle 43a de la mémoire externe 42, et que le groupes 25 de blocs ordonnés B_{35,1} à B_{35,4} a été mémorisée dans une autre zone séquentielle 43b de la mémoire externe 42. La zone séquentielle 43a et la zone séquentielle 43b ne sont pas contigües. En effet, les blocs mémoires disponibles entre ces deux zones seront utilisées pour y mémoriser ultérieurement les blocs ordonnés B_{4,5} à B_{34,N} (B_{4,5}, B_{4,6}, ..., B_{4,N}, B_{5,1}, B_{5,2}, ..., B_{5,N}, ..., B_{34,1}, B_{34,2}, ..., B_{34,N}).

La description ci-avant illustre clairement que, par ses différentes caractéristiques et leurs avantages, la présente invention atteint les objectifs fixés en proposant une méthode et un dispositif d'entrelacement (ou de désentrelacement) particulièrement bien adaptés pour des communications optiques de très haut débit entre un satellite en orbite autour de la Terre et une station terrestre.

Il est à noter que les modes de mise en oeuvre et de réalisation considérés ci-avant ont été décrits à titre d'exemples non limitatifs, et que d'autres variantes sont par conséquent envisageables.

En particulier, les valeurs du nombre N_{T} de zone tampons 16 dans la mémoire cache 15 du dispositif 10 d'entrelacement, de la taille K d'un bloc 21 de données, du nombre N de blocs 21 formant une trame 20 de données, du nombre L de trames 20 à entrelacer, ou du nombre N_{B} de blocs 21 à utiliser pour former un groupe 22 de blocs entrelacés, ont été données à titre d'exemple. Le choix d'autres valeurs pour ces paramètres ne constitue qu'une variante de l'invention.

Aussi, l'algorithme particulier décrit en référence aux figures 3 à 8, 10 et 11 n'est qu'un exemple de mise en oeuvre du procédé 100 d'entrelacement selon l'invention. D'autres variantes sont bien entendu envisageables.

En particulier, l'écriture d'une trame 20 dans une zone tampon 16 peut être effectuée bloc par bloc au fur et à mesure de la réception des blocs par le dispositif 10 d'entrelacement, ou bien en une seule fois après que tous les blocs 21 de la trame 20 ont été reçus. Aussi, bien qu'il soit plus intuitif de parcourir les zones tampons par ordre croissant des indices, rien n'empêcherait d'utiliser d'abord les zones tampons d'indices pairs, puis les zones tampons d'indices impairs. Ces différentes alternatives algorithmiques ne sont que des variantes de l'invention.

L'invention a été présentée à titre d'exemple dans le cadre d'une communication optique entre un satellite en orbite autour de la Terre et une station au sol au niveau de la surface terrestre. Rien n'empêcherait toutefois d'appliquer l'invention à une communication optique entre un satellite et une station aéroportée dans les couches basses de l'atmosphère terrestre.

## Revendications

1. Dispositif (10) d'entrelacement de blocs de données pour un système de communications optiques entre un satellite (31) et une station terrestre (30), ledit dispositif (10) d'entrelacement étant configuré pour recevoir en entrée des trames (20) de données, chaque trame comprenant plusieurs blocs (21) de données ordonnés, et pour fournir en sortie des blocs (21) de données entrelacés, ledit dispositif (10) d'entrelacement comprenant un module de contrôle (11) et une mémoire externe (12) destinée à mémoriser les blocs (21) entrelacés, ledit dispositif (10) d'entrelacement étant **caractérisé en ce qu'**il comporte en outre une mémoire cache (15) comprenant N_{T} zones tampons (16) de type « premier entré, premier sorti », N_{T} étant un entier pair supérieur ou égal à quatre, chaque zone tampon (16) ayant une taille au moins égale à la taille d'une trame (20), et pour des indices k, l, m et n initialisés à zéro, le module de contrôle (11) est configuré pour :
- pour chaque nouvelle trame (20) reçue :
∘ écrire la trame dans la zone tampon (16) d'indice k si elle est disponible,
∘ incrémenter modulo N_{T} l'indice k d'une unité;
- former itérativement des groupes (22) de blocs à écrire dans la mémoire externe (12) de la façon suivante :
∘ tant qu'il reste des blocs (21) à extraire dans la zone tampon (16) d'indice I :
▪ extraire un bloc (21) de la zone tampon (16) d'indice I,
▪ ajouter le bloc (21) extrait au groupe (22) de blocs entrelacés à former,
▪ si le groupe (22) de blocs comprend N_{T}/2 blocs, écrire le groupe (22) de blocs dans une zone séquentielle (13) de la mémoire externe (12),
▪ incrémenter modulo (N_{T}/2 -1) l'indice m d'une unité,
▪ attribuer à l'indice I la valeur (n x N_{T}/2 + m),
∘ quand tous les blocs (21) de la trame (20) mémorisée dans la zone tampon (16) d'indice I ont été extraits :
▪ incrémenter modulo 2 l'indice n d'une unité,
▪ attribuer à l'indice l la valeur (n x N_{T}/2),
une zone tampon (16) étant considérée comme disponible si et seulement si elle ne contient pas de bloc (21) n'ayant pas encore été utilisé pour former un groupe (22) de blocs entrelacés à écrire dans la mémoire externe (12).

2. Dispositif (10) d'entrelacement de blocs selon la revendication 1 dans lequel le module de contrôle (11) et la mémoire cache (15) sont intégrés sur un même circuit électronique de type circuit intégré spécifique ou circuit logique programmable, et la mémoire externe (12) est distincte dudit circuit électronique.

3. Dispositif (10) d'entrelacement de blocs selon l'une quelconque des revendications 1 à 2 dans lequel la mémoire externe (12) est une mémoire vive dynamique, dite mémoire DRAM.

4. Dispositif (10) d'entrelacement de blocs selon l'une quelconque des revendications 1 à 3 dans lequel la mémoire cache (15) est une mémoire vive statique, dite mémoire SRAM.

5. Dispositif (10) d'entrelacement de blocs selon l'une quelconque des revendications 1 à 4 configuré pour recevoir en entrée des trames (20) de données avec un débit au moins égal à 1 Gbits/s, voire au moins égal à 10 Gbits/s.

6. Dispositif (10) d'entrelacement de blocs selon l'une quelconque des revendications 1 à 5 dans lequel la taille K d'un bloc (21) de données est inférieure ou égale à 1024 bits.

7. Dispositif (10) d'entrelacement de blocs selon la revendication 6 dans lequel une trame (20) comporte un nombre N de blocs (21) de données au moins égal à 60.

8. Dispositif (10) d'entrelacement de blocs selon l'une quelconque des revendications 1 à 7 dans lequel le produit entre la taille K d'un bloc (21) de données et le nombre N_{B} de blocs formant un groupe (22) de blocs entrelacés est au moins égal à 1024.

9. Dispositif (10) d'entrelacement de blocs selon l'une quelconque des revendications 1 à 8 dans lequel le nombre L de trames à entrelacer est au moins égal à 1000.

10. Dispositif (10) d'entrelacement de blocs selon l'une quelconque des revendications 1 à 9 dans lequel la mémoire cache (15) comporte 4, 8 ou 16 zones tampons (16) de la taille d'une trame (20) de données.

11. Satellite (31) **caractérisé en ce qu'**il comporte un dispositif (10) d'entrelacement de blocs selon l'une quelconque des revendications 1 à 10.

12. Station terrestre (30) **caractérisée en ce qu'**elle comporte un dispositif (10) d'entrelacement de blocs selon l'une quelconque des revendications 1 à 10.

13. Procédé (100) d'entrelacement de blocs de données par un dispositif (10) d'entrelacement d'un système de communications optiques entre un satellite (31) et une station terrestre (30), ledit dispositif (10) d'entrelacement étant configuré pour recevoir en entrée des trames (20) de données comprenant chacune plusieurs blocs (21) de données ordonnés, et pour fournir en sortie des blocs (21) de données entrelacés, ledit dispositif (10) d'entrelacement comprenant un module de contrôle (11) et une mémoire externe (12) destinée à mémoriser les blocs (21) entrelacés, ledit dispositif (10) d'entrelacement comportant en outre une mémoire cache (15) comprenant N_{T} zones tampons (16) de type « premier entré, premier sorti », N_{T} étant un entier pair supérieur ou égal à quatre, chaque zone tampon (16) ayant une taille au moins égale à la taille d'une trame (20), ledit procédé (100) d'entrelacement comprenant :
- une phase d'écriture (200) des trames (20) dans la mémoire cache (15) comprenant :
∘ une initialisation (201) d'un indice k à zéro,
∘ une réception (202) d'une nouvelle trame (20),
∘ pour chaque nouvelle trame (20) reçue :
▪ une écriture (203) de la trame (20) dans la zone tampon (16) d'indice k si elle est disponible,
▪ une incrémentation (204) modulo N_{T} de l'indice k d'une unité;
- une phase d'écriture (300) de groupes (22) de blocs dans la mémoire externe (12) comprenant :
∘ une initialisation (301) d'indices l, m et n à zéro,
∘ tant qu'il reste des blocs (21) à extraire dans la zone tampon (16) d'indice I :
▪ une extraction (302) d'un bloc (21) de la zone tampon (16) d'indice I,
▪ un ajout (303) du bloc extrait au groupe (22) de blocs entrelacés à former,
▪ si le groupe (22) de blocs comprend N_{T}/2 blocs, une écriture (304) du groupe (22) de blocs dans une zone séquentielle (13) de la mémoire externe (12),
▪ une incrémentation (305) modulo (N_{T}/2 -1) de l'indice m d'une unité,
▪ une attribution (305) à l'indice I de la valeur (n x N_{T}/2 + m),
∘ quand tous les blocs (21) de la trame (20) mémorisée dans la zone tampon (16) d'indice I ont été extraits :
▪ une incrémentation (306) modulo 2 de l'indice n d'une unité,
▪ une attribution (306) à l'indice I de la valeur (n x N_{T}/2),
une zone tampon (16) étant considérée comme disponible si et seulement si elle ne contient pas de bloc (21) n'ayant pas encore été utilisé pour former un groupe (22) de blocs entrelacés à écrire dans la mémoire externe (12).

## Patentansprüche

1. Vorrichtung (10) zur Verschachtelung von Datenblöcken für ein optisches Kommunikationssystem zwischen einem Satelliten (31) und einer Bodenstation (30), wobei die Verschachtelungsvorrichtung (10) konfiguriert ist, um als Eingang Datenrahmen (20) zu empfangen, wobei jeder Rahmen mehrere geordnete Datenblöcke (21) umfasst, und um als Ausgang verschachtelte Datenblöcke (21) zu liefern, wobei die Verschachtelungsvorrichtung (10) ein Steuermodul (11) und einen externen Speicher (12) umfasst, der dazu bestimmt ist, die verschachtelten Blöcke (21) zu speichern, wobei die Verschachtelungsvorrichtung (10) **dadurch gekennzeichnet ist, dass** sie außerdem einen Cache-Speicher (15) mit N_{T} Pufferbereichen (16) vom Typ "First In, First Out" umfasst, wobei N_{T} eine gerade ganze Zahl größer oder gleich vier ist, wobei jeder Pufferbereich (16) eine Größe hat, die mindestens gleich der Größe eines Rahmens (20) ist, und für die Indexe k, 1, m und n, die mit Null initialisiert werden, das Steuermodul (11) konfiguriert ist, um:
- für jeden neu empfangenen Rahmen (20):
• den Rahmen in den Pufferbereich (16) mit dem Index k zu schreiben, wenn dieser verfügbar ist,
• den Index k modulo N_{T} um eine Einheit zu inkrementieren;
- iterativ Gruppen (22) von Blöcken zu bilden, die in den externen Speicher (12) geschrieben werden sollen, auf folgende Weise:
• solange noch Blöcke (21) verbleiben, die aus dem Pufferbereich (16) mit dem Index I ausgelesen werden sollen:
∘ einen Block (21) aus dem Pufferbereich (16) mit dem Index I extrahieren,
∘ den extrahierten Block (21) der zu bildenden Gruppe (22) von verschachtelten Blöcken hinzufügen,
∘ wenn die Gruppe (22) von Blöcken N_{T}/2 Blöcke umfasst, die Gruppe (22) von Blöcken in einen sequentiellen Bereich (13) des externen Speichers (12) schreiben,
∘ den Index m modulo (N_{T}/2 - 1) um eine Einheit inkrementieren,
∘ dem Index I den Wert (n × N_{T}/2 + m) zuweisen,
• wenn alle Blöcke (21) des Rahmens (20), die in dem Pufferbereich (16) mit dem Index I gespeichert sind, abgerufen wurden:
∘ den Index n modulo 2 um eine Einheit inkrementieren,
∘ dem Index I den Wert (n × N_{T/}2) zuweisen,
wobei ein Pufferbereich (16) als verfügbar angesehen wird, wenn und nur wenn er keinen Block (21) enthält, der noch nicht verwendet wurde, um eine Gruppe (22) von verschachtelten Blöcken zu bilden, die in den externen Speicher (12) geschrieben werden sollen.

2. Vorrichtung (10) zur Verschachtelung von Blöcken nach Anspruch 1, wobei das Steuermodul (11) und der Cache-Speicher (15) auf ein und derselben elektronischen Schaltung vom Typ einer spezifischen integrierten Schaltung oder einer programmierbaren logischen Schaltung integriert sind und der externe Speicher (12) von der elektronischen Schaltung getrennt ist.

3. Vorrichtung (10) zur Verschachtelung von Blöcken nach einem der Ansprüche 1 bis 2, wobei der externe Speicher (12) ein dynamischer Direktzugriffsspeicher, ein sogenannter DRAM-Speicher, ist.

4. Vorrichtung (10) zur Verschachtelung von Blöcken nach einem der Ansprüche 1 bis 3, wobei der Cache-Speicher (15) ein statischer Direktzugriffsspeicher, ein sogenannter SRAM-Speicher, ist.

5. Vorrichtung (10) zur Verschachtelung von Blöcken nach einem der Ansprüche 1 bis 4, die so konfiguriert ist, dass sie als Eingang Datenrahmen (20) mit einer Datenrate von mindestens gleich 1 Gbit/s oder sogar von mindestens gleich 10 Gbit/s empfängt.

6. Vorrichtung (10) zur Verschachtelung von Blöcken nach einem der Ansprüche 1 bis 5, wobei die Größe K eines Datenblocks (21) kleiner oder gleich 1024 Bit ist.

7. Vorrichtung (10) zur Verschachtelung von Blöcken nach Anspruch 6, wobei ein Rahmen (20) eine Anzahl N von Datenblöcken (21) von mindestens gleich 60 aufweist.

8. Vorrichtung (10) zur Verschachtelung von Blöcken nach einem der Ansprüche 1 bis 7, wobei das Produkt zwischen der Größe K eines Datenblocks (21) und der Anzahl N_{B} von Blöcken, die eine Gruppe (22) von verschachtelten Blöcken bilden, mindestens gleich 1024 ist.

9. Vorrichtung (10) zur Verschachtelung von Blöcken nach einem der Ansprüche 1 bis 8, wobei die Anzahl L der zu verschachtelnden Rahmen mindestens gleich 1000 ist.

10. Vorrichtung (10) zur Verschachtelung von Blöcken nach einem der Ansprüche 1 bis 9, wobei der Cache-Speicher (15) 4, 8 oder 16 Pufferbereiche (16) in der Größe eines Datenrahmens (20) umfasst.

11. Satellit (31), **dadurch gekennzeichnet, dass** er eine Vorrichtung (10) zur Verschachtelung von Blöcken nach einem der Ansprüche 1 bis 10 umfasst.

12. Bodenstation (30), **dadurch gekennzeichnet, dass** sie eine Vorrichtung (10) zur Verschachtelung von Blöcken nach einem der Ansprüche 1 bis 10 umfasst.

13. Verfahren (100) zur Verschachtelung von Datenblöcken durch eine Verschachtelungsvorrichtung (10) eines optischen Kommunikationssystems zwischen einem Satelliten (31) und einer Bodenstation (30), wobei die Verschachtelungsvorrichtung (10) so konfiguriert ist, dass sie als Eingang Datenrahmen (20) empfängt, die jeweils mehrere geordnete Datenblöcke (21) umfassen, und als Ausgang verschachtelte Datenblöcke (21) liefert, wobei die Verschachtelungsvorrichtung (10) ein Steuermodul (11) und einen externen Speicher (12) umfasst, der dazu bestimmt ist, die verschachtelten Blöcke (21) zu speichern, wobei die Verschachtelungsvorrichtung (10) ferner einen Cache-Speicher (15) umfasst, der N_{T} Pufferbereiche (16) vom Typ "First In, First Out" umfasst, wobei N_{T} eine gerade ganze Zahl größer oder gleich vier ist, wobei jeder Pufferbereich (16) eine Größe hat, die mindestens gleich der Größe eines Rahmens (20) ist, wobei das Verschachtelungsverfahren (100) Folgendes umfasst:
- eine Phase des Schreibens (200) der Rahmen (20) in den Cache-Speicher (15), Folgendes umfassend:
• eine Initialisierung (201) eines Index k auf Null,
• einen Empfang (202) eines neuen Rahmens (20),
• für jeden neu empfangenen Rahmen (20):
∘ ein Schreiben (203) des Rahmens (20) in den Pufferbereich (16) mit dem Index k, wenn dieser verfügbar ist,
∘ eine Inkrementierung (204) modulo N_{T} des Index k um eine Einheit;
- eine Phase des Schreibens (300) von Gruppen (22) von Blöcken in den externen Speicher (12), Folgendes umfassend:
• eine Initialisierung (301) der Indizes I, m und n auf Null,
• solange noch Blöcke (21) zum Extrahieren in den Pufferbereich (16) mit dem Index I verbleiben:
∘ eine Extraktion (302) eines Blocks (21) aus dem Pufferbereich (16) mit dem Index I,
∘ ein Hinzufügen (303) des extrahierten Blocks zu der zu bildenden Gruppe (22) von verschachtelten Blöcken,
∘ wenn die Gruppe (22) von Blöcken N_{T}/2 Blöcke umfasst, ein Schreiben (304) der Gruppe (22) von Blöcken in einen sequentiellen Bereich (13) des externen Speichers (12),
∘ eine Inkrementierung (305) modulo (N_{T}/2 - 1) des Index m um eine Einheit,
∘ eine Zuweisung (305) des Wertes (n × N_{T}/2 + m) an den Index I,
• wenn alle Blöcke (21) des in dem Pufferbereich (16) gespeicherten Rahmens (20) mit Index I abgerufen wurden:
∘ eine Inkrementierung (306) modulo 2 des Index n um eine Einheit,
∘ eine Zuweisung (306) des Werts (n x N_{T/}2) an den Index I,
wobei ein Pufferbereich (16) als verfügbar angesehen wird, wenn und nur wenn er keinen Block (21) enthält, der noch nicht verwendet wurde, um eine Gruppe (22) von verschachtelten Blöcken zu bilden, die in den externen Speicher (12) geschrieben werden sollen.

## Claims

1. Device (10) for interleaving data blocks for an optical communications system between a satellite (31) and an earth station (30), said interleaving device (10) being configured to receive as input data frames (20), each frame comprising a plurality of ordered data blocks (21), and to provide as output interleaved data blocks (21), said interleaving device (10) comprising a control module (11) and an external memory (12) intended to store the interleaved blocks (21), said interleaving device (10) being **characterised in that** it further includes a cache memory (15) comprising N_{T} buffer areas (16) of the "first in, first out" type, N_{T} being an even integer greater than or equal to four, each buffer area (16) having a size at least equal to the size of a frame (20), and for indices k, I, m and n initialized to zero the control module (11) is configured to:
- for each new frame (20) received:
∘ write the frame in the buffer area (16) of index k,
∘ increment modulo N_{T} the index k by one;
- iteratively form groups (22) of blocks to be written in the external memory (12) in the following way:
∘ so long as there are still blocks (21) to be extracted in the buffer area (16) of index I:
▪ extract a block (21) from the buffer area (16) of index I,
▪ add the extracted block (21) to the group (22) of interleaved blocks to be formed,
▪ if the group (22) of blocks comprises N_{T}/2 blocks, write the group (22) of blocks in a sequential area (13) of the external memory (12),
▪ increment modulo (N_{T}/2 -1) the index m by one,
▪ assign to the index I the value (n x N_{T}/2 + m),
∘ when all of the blocks (21) of the frame (20) stored in the buffer area (16) of index I have been extracted:
▪ increment modulo 2 the index n by one,
▪ assign to the index I the value (n x N_{T}/2),
a buffer area (16) being considered as available if and only if it does not contain any block (21) that has not yet been used to form a group (22) of interleaved blocks to be written in the external memory (12).

2. Device (10) for interleaving blocks according to claim 1 wherein the control module (11) and the cache memory (15) are integrated on the same electronic circuit of specific integrated circuit or programmable logic circuit type, and the external memory (12) is different from said electronic circuit.

3. Device (10) for interleaving blocks according to any one of claims 1 to 2 wherein the external memory (12) is a dynamic random access memory, known as DRAM.

4. Device (10) for interleaving blocks according to any one of claims 1 to 3 wherein the cache memory (15) is a static random access, known as SRAM.

5. Device (10) for interleaving blocks according to any one of claims 1 to 4 configured to receive as input data frames (20) with a rate at least equal to 1 Gbits/s, or even at least equal to 10 Gbits/s.

6. Device (10) for interleaving blocks according to any one of claims 1 to 5 wherein the size K of a data block (21) is smaller than or equal to 1024 bits.

7. Device (10) for interleaving blocks according to claim 6 wherein a frame (20) includes a number N of data blocks (21) at least equal to 60.

8. Device (10) for interleaving blocks according to any one of claims 1 to 7 wherein the product between the size K of a data block (21) and the number N_{B} of blocks forming a group (22) of interleaved blocks is at least equal to 1024.

9. Device (10) for interleaving blocks according to any one of claims 1 to 8 wherein the number L of frames to be interleaved is at least equal to 1000.

10. Device (10) for interleaving blocks according to any one of claims 1 to 9 wherein the cache memory (15) includes 4, 8 or 16 buffer areas (16) of the size of a data frame (20).

11. Satellite (31) **characterised in that** it includes a device (10) for interleaving blocks according to any one of claims 1 to 10.

12. Earth station (30) **characterised in that** it includes a device (10) for interleaving blocks according to any one of claims 1 to 10.

13. Method (100) for interleaving data blocks by a device (10) for interleaving an optical communications system between a satellite (31) and an earth station (30), said interleaving device (10) being configured to receive as input data frames (20) each comprising a plurality of ordered data blocks (21), and to provide as output interleaved data blocks (21), said interleaving device (10) comprising a control module (11) and an external memory (12) intended to store the interleaved blocks (21), said interleaving device (10) further including a cache memory (15) comprising N_{T} buffer areas (16) of the "first in, first out" type, N_{T} being an even integer greater than or equal to four, each buffer area (16) having a size at least equal to the size of a frame (20), said interleaving method (100) comprising:
- a phase of writing (200) the frames (20) in the cache memory (15) comprising:
∘ setting (201) an index k to zero,
∘ receiving (202) a new frame (20),
∘ for each new frame (20) received:
▪ writing (203) the frame (20) in the buffer area (16) of index k,
▪ incrementing (204) modulo N_{T} the index k by one;
- a phase of writing (300) the groups (22) of blocks in the external memory (12) comprising:
∘ setting (301) indices I, m and n to zero,
∘ so long as there are still blocks (21) to be extracted in the buffer area (16) of index I:
▪ extracting (302) a block (21) from the buffer area (16) of index I,
▪ adding (303) the extracted block to the group (22) of interleaved blocks to be formed,
▪ if the group (22) of blocks comprises N_{T}/2 blocks, writing (304) the group (22) of blocks in a sequential area (13) of the external memory (12),
▪ incrementing (305) modulo (N_{T}/2 -1) the index m by one,
▪ assigning (305) to the index I the value (n x N_{T}/2 + m),
∘ when all of the blocks (21) of the frame (20) stored in the buffer area (16) of index I have been extracted:
▪ incrementing (306) modulo 2 the index n by one unit,
▪ assigning (306) to the index I the value (n x N_{T}/2),
a buffer area (16) being considered as available if and only if it does not contain any block (21) that has not yet been used to form a group (22) of interleaved blocks to be written in the external memory (12).
